# EUROPEAN PATENT SPECIFICATION

(11) **EP 2 360 115 B1**
(45) Date of publication and mention of the grant of the patent: **06.06.2012**
(21) Application number: 10194892.5
(22) Date of filing: 14.12.2010
(51) Int. Cl.: B81C 99/00, H01M 8/00

(54) **Method of producing a polymer stamp for the reproduction of devices comprising microstructures and nanostructures, a corresponding polymer stamp, and a corresponding device**
Verfahren zur Herstellung eines Polymerstempels zum Abformen von Vorrichtungen mit Mikro- und Nanostrukturen, zugehöriger Polymerstempel und zugehörige Vorrichtung
Procédé de production d'un timbre en polymère pour la reproduction de dispositifs comprenant des microstructures et des nanostructures, timbre en polymère correspondant et dispositif correspondant

(30) Priority: 12.02.2010 EP 10153537
(43) Date of publication of application: 24.08.2011
(73) Proprietor: Helmholtz-Zentrum Berlin für Materialien und Energie GmbH, 14109 Berlin (DE); Consejo Superior de Investigaciones Científicas, 28006 Madrid (ES)
(72) Inventor: Senn, Tobias, 10249, Berlin (DE); Esquivel-Bojoquez, Juan Pablo, 08006, Barcelona (ES); Sabaté-Vizcarra, Neus, 08014, Barcelona (ES); Lörgen, Dr. Marcus, 15738, Zeuthen (DE)
(74) Representative: Gulde Hengelhaupt Ziebig & Schneider

(56) References cited:
- EP-A2- 1 495 799
- US-A1- 2009 041 986
- US-A1- 2009 047 478
- KETTLE J ET AL: "Fabrication of complex 3D structures using Step and Flash Imprint Lithography (S-FIL)", MICROELECTRONIC ENGINEERING, ELSEVIER PUBLISHERS BV., AMSTERDAM, NL, vol. 85, no. 5-6, 1 May 2008 (2008-05-01), pages 853-855, XP022678621, ISSN: 0167-9317, DOI: DOI:10.1016/J.MEE.2007.12.003 [retrieved on 2008-01-08]

## Description

### Field of the invention

The present invention relates to a method of producing a polymer stamp for the reproduction of devices comprising microstructures and nanostructures, a polymer stamp and a device comprising microstructures and nanostructures. It particularly relates to micro devices which could be used in micro fuel cell system as fuel delivery systems or water management systems with microstructures and nanostructures. The device preferably consists of a polymer.

### Background of the invention

Different fields of technology like nanotechnology, biotechnology or optics need fabrication techniques and materials for future development. Due to an integration of nano- and microstructures, highly functional devices in applications like fluidics, biochips or photonic crystals could be achieved. Different micro- and nanofabrication processes and three dimensional microstructure techniques are known. The growing need of polymeric devices has led to a greater importance of polymer based micromachining. Because of the variety of polymeric materials they offer good biocompatibility and chemical resistance as well as good optical properties for photonic applications.

The main replication techniques of polymer based devices are injection moulding and hot embossing and micro-machining. For nanopattern replication, nanoimprint technology (NIL) and UV-nanoimprint-technology can be used. Besides, soft lithography techniques like microcontact printing (CP) and micro-moulding have been established which offer new possibilities of nanostructuring.

However, with hot embossing it is difficult to replicate positive and negative structural features due to the different conditions during moulding. Furthermore, it is difficult to form through-holes by hot embossing. Through-holes are for instance necessary for micro fuel cell systems. Injection moulding on the other hand normally requires expensive equipment.

For further improvement of fuel cells some general problems have to be solved. One of the problems is the fuel delivery. The fuel must be transported to the anode, where the reaction takes place. During the reaction, CO₂ is produced, which must be transported out of the system to avoid a hindrance for the fuel. Therefore the separation of liquid and gas and the transportation of gas out of the device is a decisive factor for the improvement of fuel cells. Both problems can be solved by exploiting wetting properties of surfaces. For example, fuel used in such applications can easily be transported to the anode through hydrophilic channels. The CO₂ on the other hand can be separated and transported out of the device through hydrophobic channels. Thus, a device that is capable to solve those problems may contain both hydrophobic and hydrophilic channels. Besides the transportation problems, the fuel must be supplied to the system. Therefore a through-hole for fuel supply must be integrated in such a device as well, which is difficult to form with hot embossing.

From US 20060029858 A1 a diffusion medium for use in a PEM fuel cell contains hydrophobic and hydrophilic areas for improved water management. A hydrophobic polymer such as a fluororesin is used to define hydrophobic areas, and an electroconductive polymer such as polyaniline or polypyrrole is used for defining hydrophilic areas. However, two different polymers need to be used for the formation of such channels making the fabrication process very complex.

DE 102 32 129 A1 discloses a fluid distribution device for an electrochemical electrode, wherein coatings are used to form hydrophobic and hydrophilic areas. However, a coating exhibits a limited lifetime. Moreover, each final product needs to be coated separately with the coating in order to produce hydrophobic and hydrophilic areas.

Patent application publication US 2009/041986 A1 teaches first the formation of nanostructures on a substrate which is subsequently followed by formation of microstructured layers on top of the nanostructures. The microstructures are formed by lithographic methods. These methods use a shadowing effect to form the structures which does not allow formation of structures on side walls. The hierarchical article obtained in this way can be used as a mould to generate a replica that has a negative relief image of the original hierarchical article.

### Summary of the invention

It is therefore an object of the present invention to provide a method of producing a polymer stamp or mould as well as a device from the polymer stamp or mould, in which the nanostructures and microstructures are incorporated into the stamp or mould and are transferred to the final device from the stamp or mould. It is also an object to provide a passive device for a fuel cell system, which exhibits hydrophobic and hydrophilic areas in a simplified way at lower costs for separation of gaseous by-products from liquid fuels.

Accordingly, in a first embodiment the present invention provides a method of producing a polymer stamp or mould for the reproduction of devices comprising microstructures and nanostructures, the method comprising the steps of providing a thermoplastic foil, providing a first substrate, patterning nanostructures into the thermoplastic foil, patterning microstructures onto the first substrate, covering the first substrate surface comprising the microstructures with the nanostructured thermoplastic foil, casting a polymer elastomer onto the first substrate with nanostructures and microstructures to form a polymer stamp and releasing the polymer stamp.

The use of the foil has the advantage that nanostructures can be transferred directly onto the microstructures in all dimensions.

The step of patterning nanostructures into the thermoplastic foil preferably comprises the step of forming hydrophilic sections along a first direction and hydrophobic sections along a second, different direction by arranging the nanostructures to extend along a first direction, the second direction being preferably perpendicular to the first direction.

The step of patterning nanostructures into the thermoplastic foil comprises the step of hot-embossing nanostructures into the foil.

Alternatively, the step of patterning nanostructures into the thermoplastic foil comprises the steps of imprinting the nanostructures onto the thermoplastic foil by UV nanoimprinting lithography.

The UV nanoimprinting lithography step comprises the steps of forming a thermoplastic foil by providing a thermoplastic material layer, covering one side of the thermoplastic material layer with a polymer material layer and covering the opposite side of the thermoplastic material layer with an UV curing material layer, making contact between a polymer stamp with nanostructure cavities and the side of the thermoplastic material layer where the UV curing material layer is applied, filling of the nanostructure cavities in the polymer stamp with UV curing material of the UV curing material layer, exposing the assembly to UV radiation, and peeling-off the polymer stamp of the thermoplastic foil.

The polymer stamp with nanostructure cavities may be formed by the steps of providing a substrate material, covering the substrate material with a resist, coating a metal onto the covered substrate, lifting-off the metal partially to form nanostructures and etching the substrate.

The step of covering the first substrate surface preferably comprises the step of deforming the thermoplastic foil onto the microstructures by thermoforming.

The thermoforming step preferably comprises heating up the first substrate with the thermoplastic foil on top to a temperature above the glass transition temperature of the foil.

The step of patterning nanostructures may comprise at least one of the steps of forming the nanostructures as lines and spaces extending in the first direction.

The step of pattering microstructures preferably comprises at least one of the steps of forming first microstructures to extend along the first direction to form hydrophilic channels together with the nanostructures extending in said first direction, and forming second microstructures to extend along a second, different direction to form hydrophobic channels together with the nanostructures extending in the first direction.

The microstructure patterning step may comprise at least one of the steps of covering the first substrate with a second resist being a photo resist and performing a lithography process to form microstructures in the second resist, and forming a through hole through the second resist and the first substrate. However, the microstructure patterning step is not limited thereto but could be performed by different methods, for instance by micro-milling.

The through-hole may be formed by potassium hydroxide etching, deep reactive ion etching, microdrilling or -milling, or laser ablation. Advantageously, the casting step of the stamp and the final product allows to easily incorporate a through-hole into the final product required for instance in fuel cell applications. The through-hole and the micro- and nanostructures are formed in the final product in a single casting step.

It is further provided a method of reproducing devices comprising microstructures and nanostructures comprising the steps of casting a final product material onto the polymer stamp comprising microstructures and nanostructures produced by the method of producing a polymer stamp according to the invention, wherein the microstructures and nanostructures are transferred during the casting step to the final product, and releasing the final product of the polymer stamp.

The final product material used for casting may be a polymer material.

It is further provided a polymer stamp comprising first microstructures extending along a first direction, second microstructures extending along a second direction different from the first direction, and nanostructures being provided to extend at least along said first direction, wherein the nanostructures are patterned into the at least one surface of the first and/or second microstructures and are formed of the same material as the microstructures themselves, and wherein the aspect ratio of a single nanostructure element is larger than 5, preferably larger than 10. The nanostructures are formed on the bottom and the side walls of the first and/or second microstructures of the polymer stamp.

In addition, a device is provided comprising first microchannels extending along a first direction, second microchannels extending along a second direction different from the first direction, and nanostructures provided to extend at least along said first direction, wherein the nanostructures are patterned into the surface of the microchannels and are formed of the same material as microchannels themselves, and wherein the aspect ratio of a single nanostructure element is larger than 5, preferably larger than 10. The nanostructures are formed on the bottom and side walls of the first and/or second microchannels.

In other words, the nanostructures are formed of the same material as the microchannels themselves or are formed of the same material as the bulk material of the microdevice. Preferably, the device consists of a single material or material compound and the nanostructures are formed of this device material. No additional layers, no coating or chemical treatment with molecules is required. The topography of the polymer stamp material is physically changed at its surface. The surface is functionalized by the topographic structures.

The final product material used for casting preferably comprises polymer materials. It may comprise a photo resin, an epoxy-based resin, a thermal-curing material, an UV curing material, or a thermoplastic material. Polymer materials in general have the advantage of a good biocompatibility and chemical stability and resistance against fuels like ethanol and methanol as well as good optical properties.

The device is preferably a single, fully integrated component. An assembly is not required.

The microchannels consist of the microstructures as the side walls, wherein at least on the bottom of the microchannel the nanostructures are provided. They may also be provided on the side walls and top wall of the microchannels.

According to the invention, a simple and low cost casting step on the polymer stamp can be employed to repeatedly form the final product under the transfer of micro- and nanostructures to the final product.

It is emphasized that the stamp exhibits the inverse structure of the final product. Thus, a bottom of the channel in the final product will be a top in the stamp. However, for ease of reading and understanding, in the following we will usually refer to the orientation of the structures of the final product instead of the stamp, unless specifically stated otherwise.

Through the provision of the nanostructures on the foil or in the substrate surface, hydrophilic and hydrophobic areas can be created in the respective surfaces without any additional layers or chemical coatings. The surfaces are functionalized by topographic nanostructures.

Further, by aligning the microstructures with the nanostructures, hydrophilic channels can be created. The channels have the microstructures as the side walls and the nanostructures are formed at least on the bottom of the microstructures. The microstructures provide guides for a fluid along the direction in which the nanostructures are formed. However, along a different, second direction, the nanostructures become more and more hydrophobic. The maximum of hydrophobicity is established in a direction perpendicular to the first direction. If microstructures are now formed along this second, preferably perpendicular direction as well, hydrophobic and hydrophilic structures are formed simply by the mutual alignment or misalignment of nano- and microstructures.

The step of patterning microstructures preferably further comprises at least one of the steps of forming the first microstructures with a width of 50-500µm, preferably 100-200µm and a height of 10-1000µm, preferably 50-200µm, and forming the second microstructures with a width of 1-100µm, preferably 5-50µm and a height of 10-1000µm, preferably 50-200µm.

The size ranges of the microstructures improve their desired functionality as hydrophilic or hydrophobic channels.

The step of patterning nanostructures comprises at least one of the steps of forming the nanostructures with a pitch of 50nm-3500nm, preferably 500-1 000nm and/or providing the nanostructures with a cross-section being triangular, rectangular or pillar-shaped and forming the nanostructure as lines and spaces. The aspect ratio of the height to the width of the nanostructures is preferably larger than 5, even more preferably larger than 10.

The size ranges of the nanostructures or -patterns maximize their distinguishing character of being hydrophilic in a first direction and hydrophobic in a second, different direction.

The lines and spaces provide a very simple way to direct fluids into their direction of extension. In the direction of the lines and spaces, the nanostructures are hydrophilic. In a second, different direction, their character becomes hydrophobic, with a maximum of hydrophobicity along the perpendicular direction.

The second resist preferably comprises polymethylmethacrylate, phenolic resins or epoxy-resins.

Prior to the step of casting a polymer elastomer onto the first substrate the method may further comprise the steps of cutting the first substrate to obtain a pre-master comprising the nanostructured first substrate and the microstructured resin, and fixing the pre-master on a second substrate.

The polymer elastomer preferably comprises polydimethylsiloxane (PDMS). PDMS has advantageously a relative low absorption rate for UV applications.

The nanostructures provide a contact angles of 0°-90°, preferably 30°-75° along the first direction, and 90°-160°, preferably 110-150° along the second direction. Preferably, they have a pitch of 50nm-3500nm, more preferably 500-1000nm. The aspect ratio of the height to the width of the nanostructures is preferably larger than 5, even more preferably larger than 10. The nanostructures are preferably provided with a cross-section being triangular, rectangular or pillar-shaped. They may be provided as lines and spaces. The lines extend along the first direction.

The first micro-channels have a width of 50-500µm, preferably 100-200µm and a height of 10-1000µm, preferably 50-200µm. The second micro-channels have a width of 1-100µm, preferably 5-50µm and a height of 10-1000µm, preferably 50-200µm.

The device is preferably a micro-device. In one embodiment, the device forms a part of a micro fuel cell system wherein the device is preferably a fuel delivery system, the first microchannels are fuel delivery microchannels, and the second microchannels are gas exhaust microchannels and the through-hole is a fuel supply. In another embodiment, the device is a water management system of a fuel cell system, the first microchannels are water outlet microchannels, the second microchannels are used as reactant supplies and the through-hole is a water exit. The reactant is preferably oxygen.

Thus, the device according to the invention can be used in fuel cell applications, wherein the separation of liquids and gases and the transportation of gases out of the device is achieved by the relative arrangement of first microstructures along the direction of extension of nanostructures on the one hand and second microstructures along a second, different, preferably perpendicular direction thereto on the other hand.

The hydrophobic surfaces of the microchannels can be used for gas separation. The microstructures, preferably the second microstructures may form openings in side walls of the device for the separation/exhaust of gaseous by-products created during operation of the fuel cell.

The microchannels allow advantageously a passive flow of fluids.

The transport is capillary and diffusion driven and therefore the device of the present invention can be used as a passive device for a fuel cell system. The transport is also orientation independent. The device can be easily integrated or bonded to a micro fuel cell system.

### Brief description of the drawings

These and other features and aspects of the present invention will become apparent and more readily appreciated from the following description of some exemplary embodiments, taken in conjunction with the accompanying drawings of which:
- Fig. 1: shows a first step of producing a polymer stamp according to a first embodiment, the provision of a substrate,
- Fig. 2: shows a substrate of Fig. 1 covered with a first resist,
- Fig. 3: shows a nanostructured substrate of Fig. 2,
- Fig. 4: shows the nanostructured substrate of Fig. 3 covered with a second resist,
- Fig. 5: shows the nanostructured substrate with microstructures formed on top,
- Fig. 6: shows a pre-master comprising microstructures and nanostructures and a through-hole,
- Fig. 7: shows the pre-master of Fig. 6 attached to a second substrate,
- Fig. 8: shows the polymer stamp casting,
- Fig. 9: shows the polymer stamp,
- Fig. 10: shows the cast final product,
- Fig. 11: shows a top view of the polymer stamp of Fig. 9,
- Fig. 12: shows a cut through the polymer stamp of Fig. 11 along the line A-A,
- Fig. 13: shows the casting step of the final product using the stamp of Fig. 12,
- Fig. 14: shows a cut through a final product of a first embodiment along a corresponding to line A-A of Fig. 12,
- Fig. 15: shows a fuel cell application of two devices according to a present invention,
- Fig. 16: shows a contact angle measurement of nanostructures parallel to their direction of extension and perpendicular thereto,
- Fig. 17: shows a first step of an alternative embodiment of forming a polymer stamp, according to the invention, the provision of a foil,
- Fig. 18: shows the foil of Fig. 17 patterned with nanostructures,
- Fig. 19: shows the patterned foil of Fig. 18 covering a substrate with microstructures,
- Fig. 20: shows a casting step on top of the device of Fig. 19,
- Fig. 21: shows the casted polymer stamp according to a second embodiment,
- Fig. 22: shows the casting of a final product using the stamp of Fig. 21,
- Fig. 23: shows the released final product,
- Fig. 24: shows a substrate with nanostructures used in a second embodiment of forming a nanostructured foil,
- Fig. 25: shows a substrate with nanostructures of Fig. 24 covered with a polymer layer,
- Fig. 26: shows a peeled-off polymer layer with nanostructured cavities in its top surface,
- Fig. 27: shows a thermoplastic foil comprising three layers, a thermoplastic material layer in the middle, a polymer layer below and an UV curing material layer on top,
- Fig. 28, 29: show the contact making of the polymer layer with nanostructured cavities and the thermoplastic foil,
- Fig. 30: shows the peeled-off thermoplastic foil with nanostructures extending from its top surface after UV exposure,
- Fig. 31: shows the thermoforming process of the thermoplastic foil onto a microstructured substrate,
- Fig. 32: shows a casting step of casting a polymer material onto foil covered substrate of Fig. 31,
- Fig. 33: shows a casting step of casting a final product onto the peeled-off polymer material of Fig. 32,
- Fig. 34: shows a final product with nanostructures and microstructures.

### Detailed description of the drawings

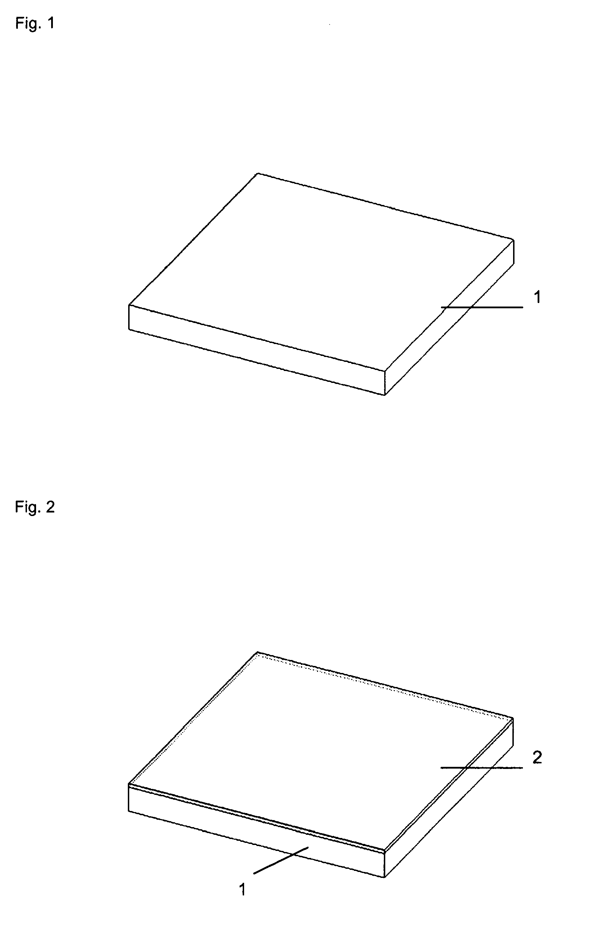

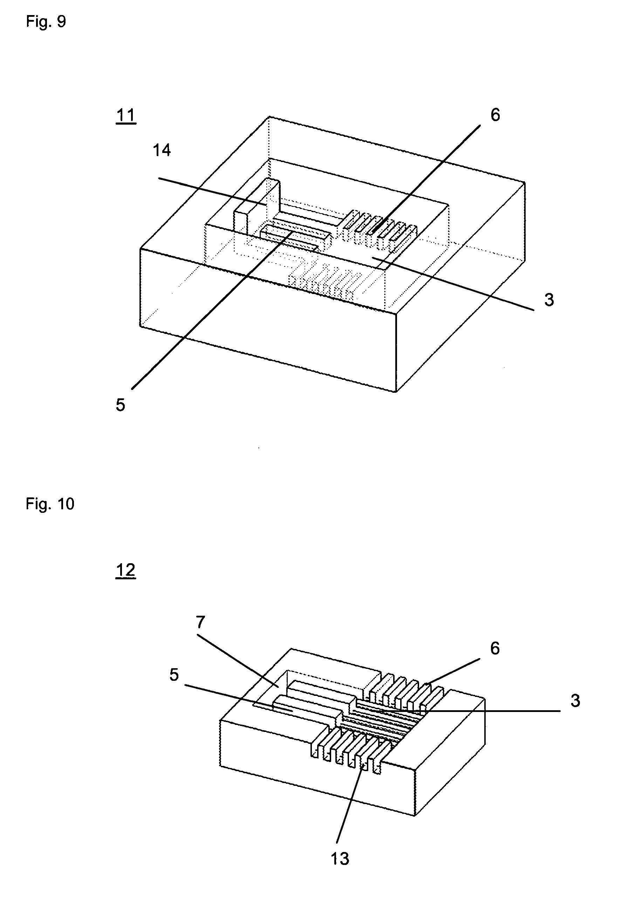

Figs. 1 to 10 show the method of producing a polymer stamp or mould of Fig. 9 and a final product of Fig. 10 according to a first embodiment. Exemplarily, the stamp is formed to produce a component for a fuel cell system. However, other applications like optics are also possible. Thus, the production of the stamp and the final product itself is not limited to fuel cell applications but rather to applications which require the formation of nanostructures along with microstructures.

Fig. 1 shows the first step of the method of producing a polymer stamp with nanostructures and microstructures according to the first embodiment, the provision of a first substrate 1. The first substrate 1 may a silicon wafer, may comprise glass or a thermoplastic polymer, but is not limited thereto. The first substrate 1 may be formed of a single material or material compound or may comprise different layers.

In a second step, nanostructures 3 are transferred into the first substrate surface. This may be done by means of nanolithography processes, preferably by UV lithography, nanoimprint lithography, hot embossing, e-beam lithography, interference lithography, X-ray interference lithography.

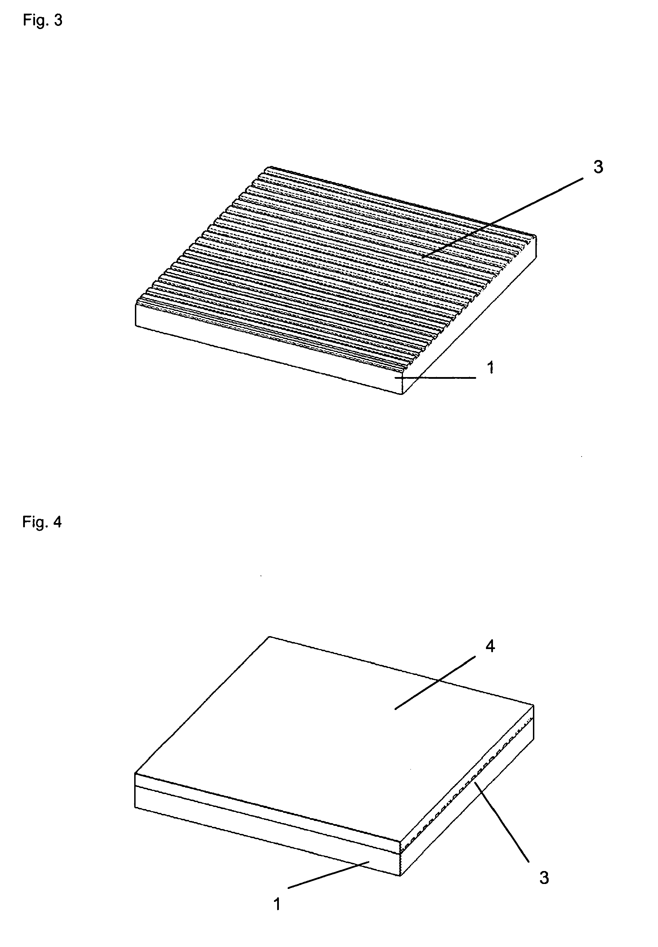

In an exemplary embodiment, the step of patterning nanostructures 3 into the first substrate 1 preferably comprises the steps of covering the first substrate with a first resist as shown in Fig. 2. Then, nanostructures are transferred or formed into the first resist by means of one of the above mentioned nanolithography processes. For instance, the nanostructures may be lines and spaces as shown in Fig. 3. However, the lines may also consist of separate elements like columns, pyramids and so on. The cross section of the lines or the nanostructures 3 may be rectangular, triangular etc.. It is only necessary to provide a smaller spacing of the nanostructures 3 in the desired first direction than in the second, different direction. The first substrate 1 with the nanostructured first resist 2 is subsequently covered with a metal layer (not shown). The first resist 2 is then removed with the metal on top, wherein the areas of the first substrate 1 without the first resist 2 remain covered by the metal. These covered parts act like a mask for an etching process of nanostructures 3 into the parts of the first substrate 1 not covered with the metal. Thus, the etching may form valleys into the surface of the first substrate 1, and the covered parts may remain as plateaus. In other words, if the first resist 2 is patterned with lines, the lines become the bottoms of nanostructured channels, the metal covered parts form spaces between the channels connecting the channel side walls. Finally, the metal is removed from the first substrate 1 as can be seen in Fig. 3 and a nanostructured first substrate surface remains.

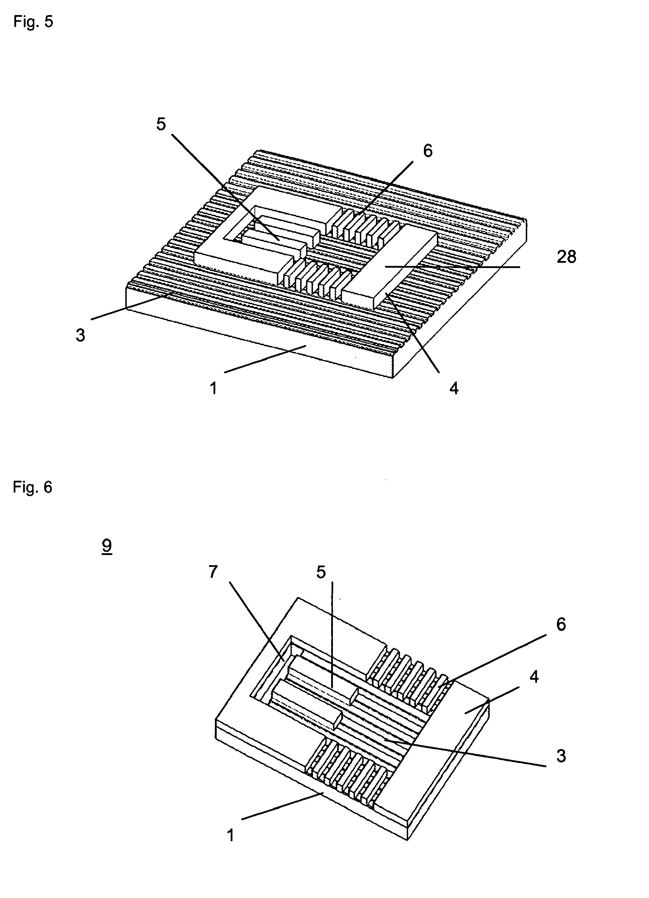

The next step of the fabrication process is shown in Fig. 4, the formation of a second resist 4 on the nanostructures surface of the first substrate 1. The second resist 4 is than patterned to exhibit first microstructures 5 and second microstructures 6 as well as other structures like further side walls 28 (Fig. 5). The structure as displayed in Fig. 5 surrounded by the second resist structures 28 is equivalent to the structure of the final product.

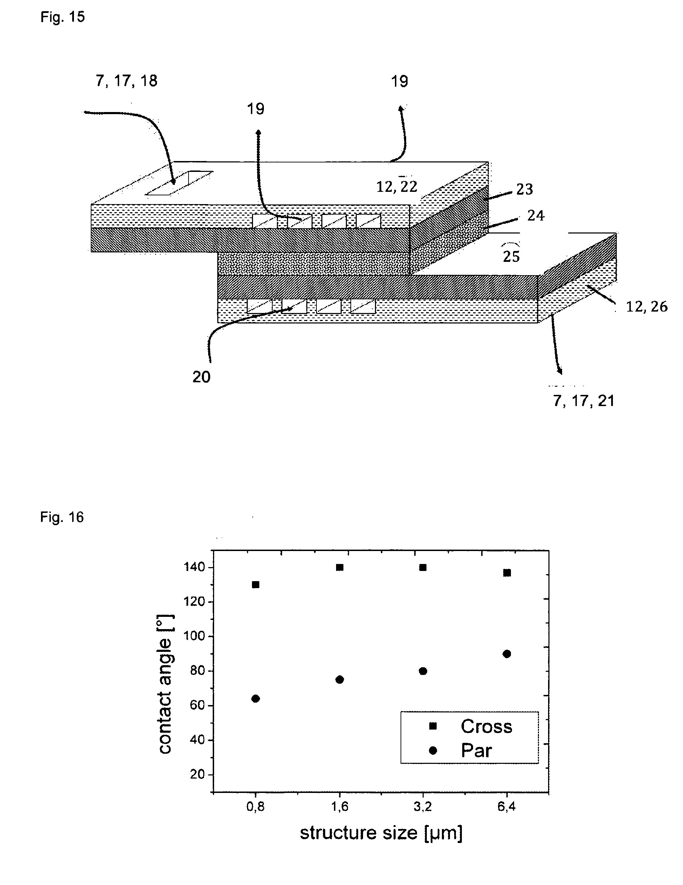

In the present embodiment, in order to, for instance, form a water management system 26 or a fuel delivery system 22 of Fig. 15, the first microstructures 5 are formed along the direction of extension of the nanostructures 3 thereby forming hydrophilic structures for a fluid transport. The second microstructures 6 are formed in a second, perpendicular to the direction of extension of the nanostructures 3 (being the direction of the valleys in Fig. 5) thereby forming hydrophobic structures, which can be used for a liquid/gas separation. The gas is transported along the second microstructures 6 to the periphery of the photo resists structures 4. The first and second microstructures 5, 6 are connected via an area of nanostructures 3, only.

In a preferred embodiment, also a through-hole 7 is formed through the second resist 4 and the first substrate 1. This is preferably done by potassium hydroxide etching, deep reactive ion etching, microdrilling or micromilling, or laser ablation.

The device is then cut along the periphery of the second resist 4 patterns, preferably by a laser. The cut-out device of Fig. 6 could be called a pre-master 9. The pre-master 9 already comprises a through-hole 7, first and second microstructures 5, 6, nanostructures 3 and further side walls 28. The pre-master 9 comprises in the exemplary embodiment the substrate layer 1 with nanostructures 3 in its surface and further structures like first and second microstructures 5, 6 and side walls 28 on its surface.

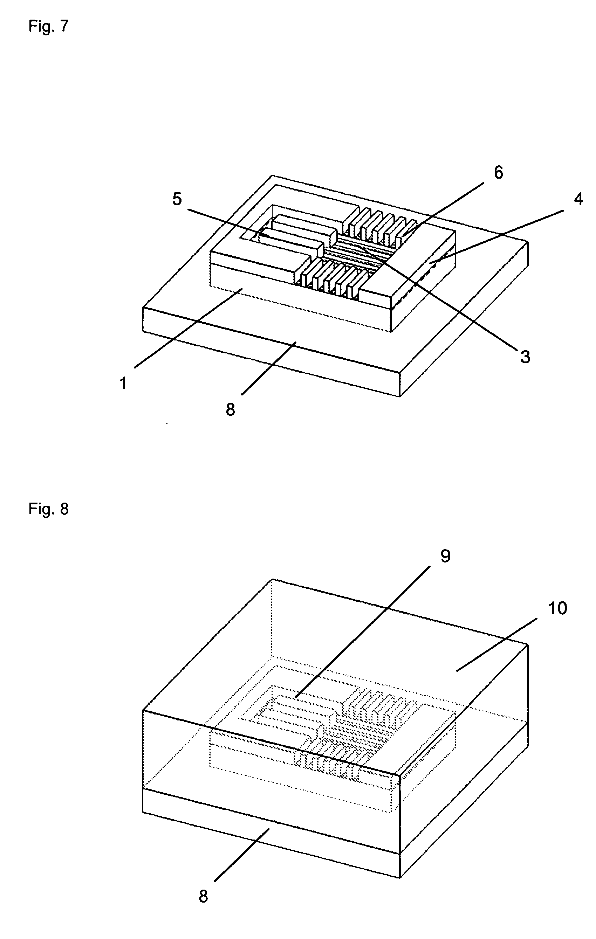

The pre-master 9 is then - preferably but not limiting - fixed on a second substrate 8 (Fig. 7).

In a further step, the first casting process takes place, i.e. a polymer material 10 is cast on top of the pre-master 9 attached to the second substrate 8 as shown in Fig. 8. For this, a frame may be used around the pre-master 9. In a final step of producing the polymer stamp 11, the stamp 11 is released from the pre-master 9 (Fig. 9). The polymer stamp 11 now has the inverse structure of the pre-master 9, i.e. were the pre-master 9 had hills, the stamp 11 has valleys and vice versa. In the preferred but not limiting embodiment, also a through hole fabrication structure 14, a column, can be seen.

In a last step, a final product material is filled into the stamp 11 and the final product 12 of Fig. 10 is formed in a casting process. The final product 12 has the same structural elements as the pre-master, i.e. a through-hole 7, first and second microstructures 5, 6, nanostructures 3 and further side walls 28. However, the final product 11 consists of a single material. No substrate is present anymore. During casting, the micro- and nanostructures are transferred to the final product. The final product has openings 13 at its side walls being in communication with second microchannels formed by the second microstructures 6 as side walls and the nanostructures 3 forming the bottom of the microchannels. The first microchannels 5 are perpendicular to the second microchannels 6. The first and second microchannels 5, 6 form a T-like structure. The areas of the first and second microchannels 5, 6 do preferably not overlap with each other, having an area, e.g. rectangular, with nanostructures 3 only in between used for the separation of liquids and gases. As the fuel liquid cannot enter the hydrophobic second microchannels, the gaseous by-products can escape through said microchannels.

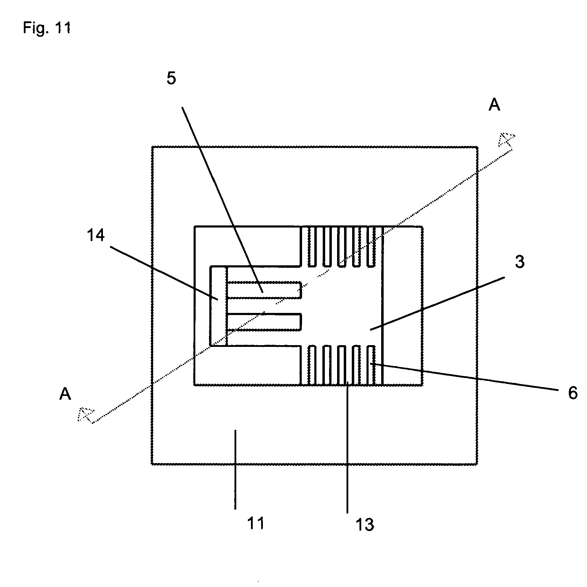

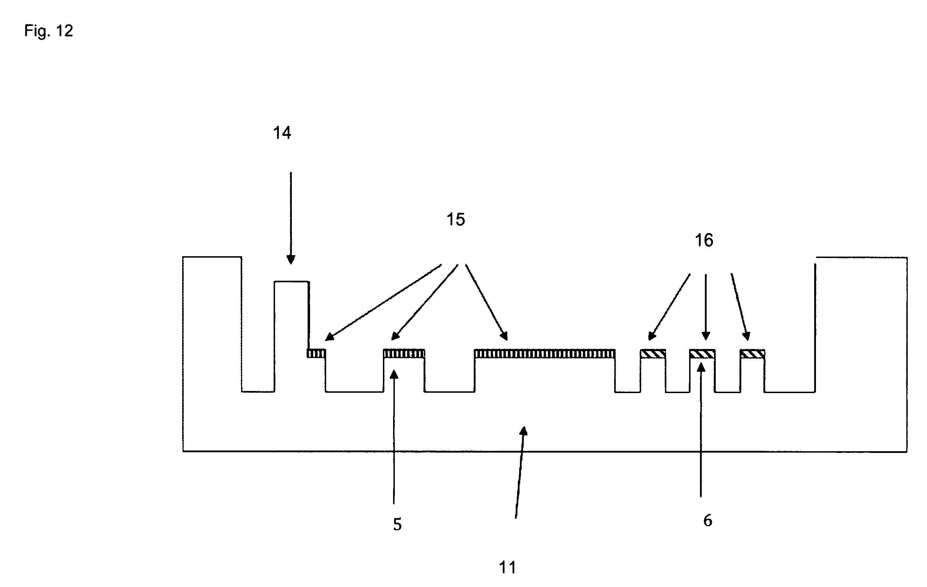

Fig. 11 shows a top view of the polymer stamp of Fig. 9. The nanostructures 3 are not specifically shown in Fig. 11, only their location is pointed out by the reference sign 3. Fig. 12 shows a cut through the stamp of Fig. 11 along the line A-A, a diagonal line starting in a stamp side wall, through the through-hole fabrication structure 14, first microstructures 5, a nanostructured-only area 3 and second microstructures 6. Hydrophilic nanostructured surfaces 15 are formed on top of the structures used for the fabrication of the first microstructures 5. However, it is pointed out that stamp 11 exhibits an inverse structure as that of the final product 12, i.e. a column of the stamp 11 of Fig. 12 is a valley in the final product 12. Thus, in the final product 12, the hydrophilic nanostructured surfaces 15 are the bottom surface of the respective microchannels 5. The same holds for the hydrophobic nanostructured surfaces 16 formed on the inverse second microstructures 6.

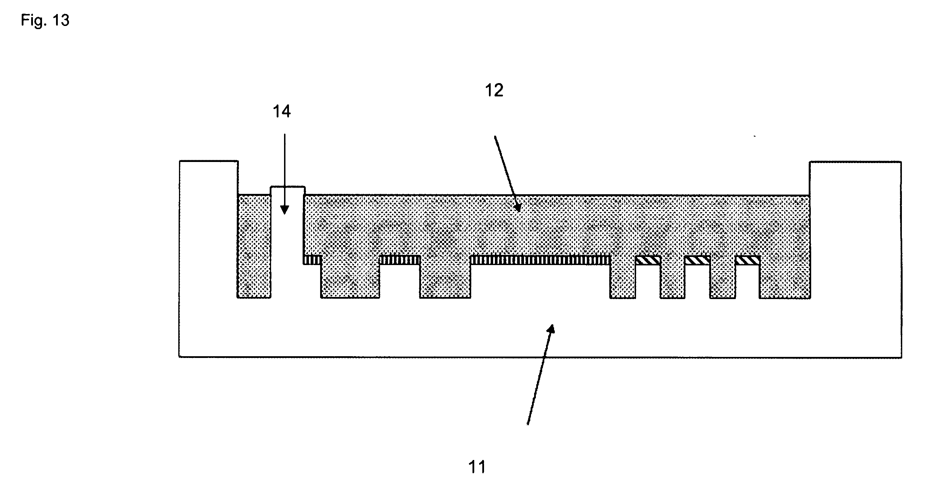

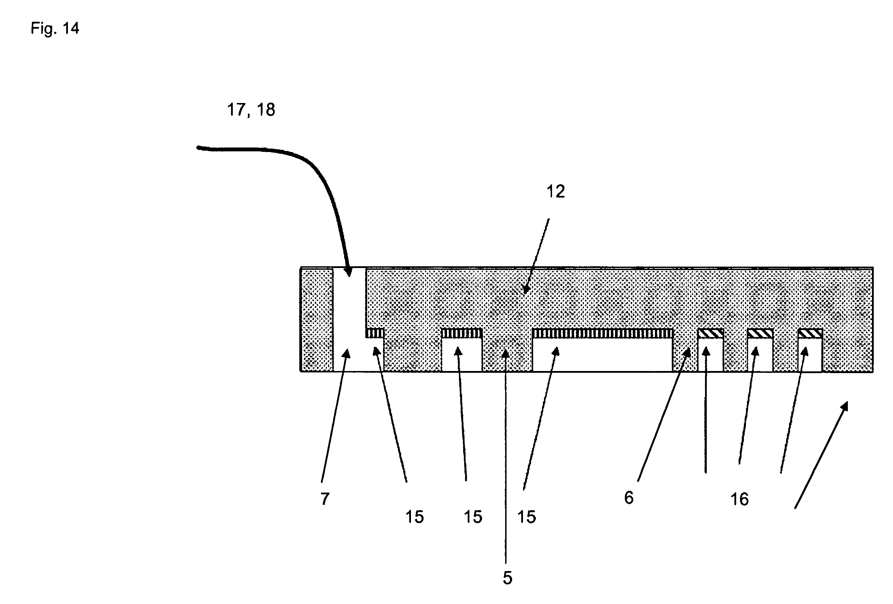

The casting process of the final product 12 is shown in Fig. 13. A final product material is filled into the stamp 11. In order to form a through-hole 7, the level of the final product material does not exceed the top of the through-hole fabrication structure 14. During the casting process, the nanostructures are transferred to the final product 12 as shown in Fig. 14. The through-hole 7 is formed along with the nano- and microstructures 3, 5, 6 in a single casting step. The through-hole 7 could for instance be used as an inlet 17 for fuel 18.

In a specific detailed, not limiting embodiment, the following monomer was used as UV curing second resin 4: a diglycidyl ether of bis-phenol A (DGE-BPA). A triaryl sulfonium salt (TAS) was used as a photoinitiator. As materials for the stamp 11 a poly(dimethylsiloxane) PDMS was used. This type of PDMS is suitable as stamp material for UV applications as its absorption characteristic shows that a relative low absorption takes place.

For the soft stamp fabrication of the detailed, not limiting embodiment, a frame was employed, which is suitable for the fabrication of four inch PDMS stamps 11. For the master fabrication for the 3D stamp 11, a positive first resist 2 was coated on a four inch first substrate 1, a silicon wafer, followed by UV Lithography for structuring the resist, Ni evaporation and a lift-off process to define the etch mask for the nanostructures 3. The nanostructures 3 were transferred using a reactive ion etching process followed by nickel removal. The structures exemplarily but not limiting consist of lines and spaces with a width of 800 nm and 1.6 µm, respectively. On this structured first substrate 1, a second exposure using an epoxy-based resin 4 was realized. Here, a 100 µm thick layer of the epoxy-based resin 4 was coated on the first substrate 1 and structured by UV-lithography using a foil mask. In the last step, the so prepared three dimensional structures were separated by a laser cutting technique. Also, a through hole 7 for delivery entrance was realized like that.

In the next step of the detailed, not limiting embodiment, the stamp 11 was fabricated. A PDMS prepolymer was used. For the transfer of nanostructures into a PDMS stamp, the wettability and the viscosity are decisive factors for good replication accuracy. Therefore, the PDMS mixture was diluted to 70 wt% with toluene to lower the viscosity and to enhance the wettability properties. The mixed blend was cast on the the first substrate 1 and the bonded structures on top of the first substrate 1 and left undisturbed for 24 hours to provide enough time for the penetration of the solution into the structure. It was then heated up to 70°C for 30 min to ensure a complete curing and solvent evaporation. After curing, the PDMS stamp could be peeled easily from the structured master. For the replication of nanostructures and microstructures, a mixture of DGE-BPA with 5 wt-% of TAS was used. This mixture was cast onto the PDMS stamp 11 and degassed for 5 min. Then a thin foil of polycarbonate was placed on the stamp 11 to define the surface quality of the replication. The exposure was realized with a dose of 1440 mJ/cm². The cured micro- and nanostructured part could be easily peeled of the master structure and released from the polycarbonate foil.

Fig. 16 shows a fuel cell application of the final product or device 12. Here, the device formed according to the invention is exemplarily but not limiting used a fuel delivery system 22 and as a water management system 26 of a fuel cell. A first device 12 formed according to the invention is placed on top of a first electrode 23, preferably an anode. The through-hole 7 is used as an inlet 17 for fuel 18. The first device 12 is placed upside-down with respect to Fig. 12 onto the first electrode 23 and attached thereto. The first electrode 23 is attached below to a membrane 24 which is attached below to a second electrode 25, preferably a cathode. The cathode 25 is attached below to a second inventive device 12. The second inventive device 12 is oriented as shown in Fig. 12.

The first device 12 is a fuel delivery system 22. Fuel is supplied through-the through hole 7. The through-hole 7 is in communication with first microchannels formed by the first microstructures 5 and the nanostructures 3. They guide a fluid to the membrane 24 were the reaction takes place. Gaseous by-products of the reaction are separated from the fuel 18 through the nanostructures 3 and are guided along second microchannels formed by the second microstructures 6 and the nanostructures 3. On the cathode side, water 21 exits the water management system 26 through the respective through-hole 7. Oxygen as a reactant is fed through the second microchannels to the cathode 25.

The nanostructures 3 are used to change the wetting properties of surfaces. The here presented device 12 uses this effect to integrate hydrophobic and hydrophilic channels 6, 5. Besides, due to the used casting process a through hole 7 could be created to realize a fuel supply 17. Contact angle measurements as shown in Fig. 16 were done to measure an optimized structure size for the realization of the fuel delivery system. In this system it is important that the difference between hydrophobic and hydrophilic properties of the channels is maximized. For instance, lines and spaces structures 3 show different contact angles depending on the direction. For the cross direction, larger contact angles were measured than parallel to the lines.

For an exemplary test, a structure consisting of lines and spaces with a width and pitch of the lines of 800 nm 1,6 µm, 3,2 µm and 6,4 µm were used, respectively. These structures were etched 1 µm deep into the silicon substrate and replicated as described above. The results of the contact angle measurement are summarized in Fig. 16. The largest difference between hydrophobic and hydrophilic behaviour results for structures with a 800 nm and 1,6 µm wide lines and spaces. Besides the measurement of the structured resin, the pure resin and a sample of an unstructured epoxy-based negative photoresist was measured as well. The measurement of the epoxy-based negative photoresist is important because the final structure may be bonded to epoxy-based negative photoresists to achieve closed channels, i. e. to form a cap of the structure. However, different materials may be used. The result of these measurements show, that both materials have a contact angle of about 65° therefore present hydrophilic properties.

Based on the results of the contact angle measurement a design was developed to exploit the effect of the direction depending wetting properties of the structure. Therefore the design was chosen as in Fig. 12. The hydrophilic channel structures 5 were aligned parallel to the nanostructured lines 3 and the hydrophobic channels 6 orthogonal to the lines 3. The channel height may be 100µm. For a test, a drop of a 5 mol-% solution of ethanol was put on the entrance of the device 12. The solution easily passes through the hydrophilic channels 5 and the hydrophilic area adjacent to the channels 5, connecting the hydrophilic channels 5 with the hydrophobic channels 6. However, as the wetting properties of the channels with orthogonal lines differ strongly form those of the channel with parallel lines, the solution is not able to enter the orthogonal channels 6.

Due to this effect a system could be created which can be used as a fuel delivery system for fuel cell applications. The fuel 18 can be transported through the hydrophilic channels 5 to the area in the middle of the structure were it can be provided to the fuel cell. The CO₂ which is produced during the reaction can escape through the hydrophobic channels 6.

Thus, the wetting properties of the channels 5, 6 were changed using nanostructures without any additional chemical treatment

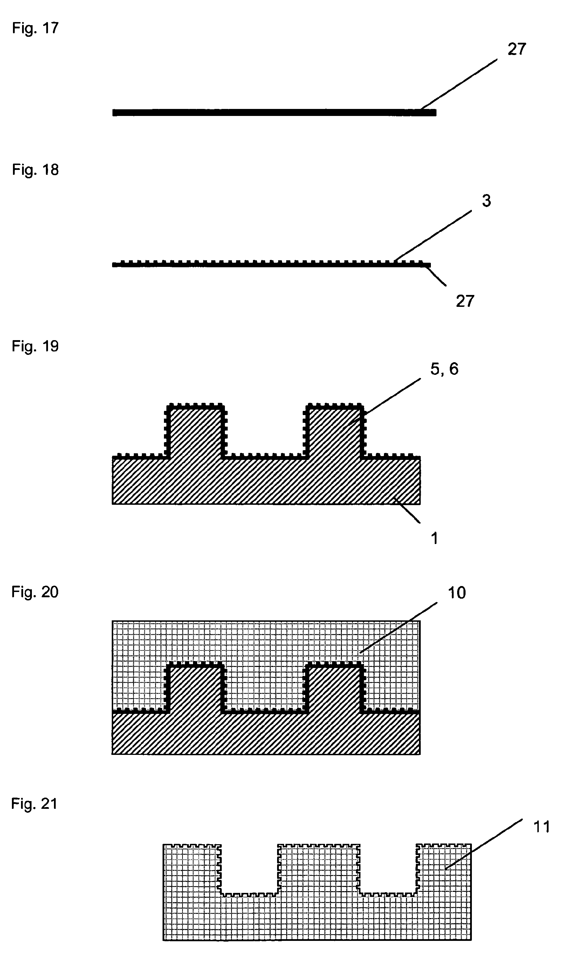

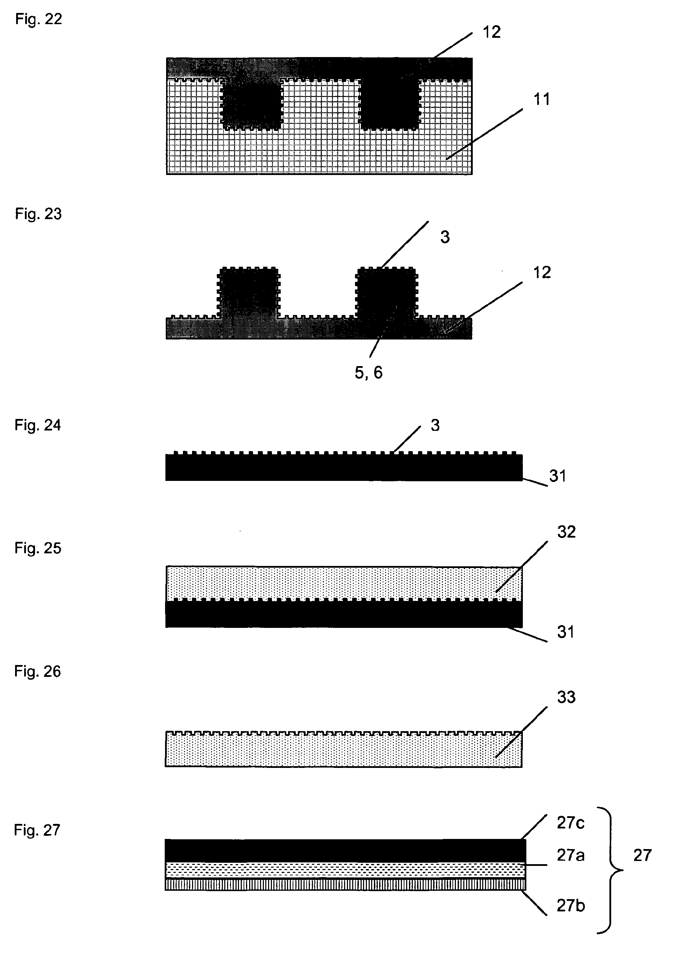

Figs. 17 to 23 show the method of producing first a polymer stamp of Fig. 21 and a final product of Fig. 23 according to a second, alternative embodiment. The second embodiment is similar to the first embodiment, apart of the formation of the nanostructures. Thus, only the differences to the first embodiment are described below. It is rather referred to the description of the first embodiment.

First, a thermoplastic foil 27 is provided as shown in Fig. 17. Then, nanostructures 3 are formed onto the foil 27, preferably by hot-embossing (Fig. 18). The foil 27 with the nanostructures 3 is subsequently placed over a first substrate 1 being provided with microstructures 5, 6 as described above. The foil 27 is preferably deformed to cover the surface of the first substrate 1 by thermoforming (Fig. 19). In a further step, a polymer material, preferably PDMS, is cast onto the first substrate 1 as described in the first embodiment (Fig. 20). The stamp 11 is released in Fig. 21 and the final product is cast onto the stamp 11 (Fig. 22) and released (Fig. 23).

The so obtained final product 12 has the advantage that the nanostructures are not only formed on the bottom of the microchannels, but also on their side and top walls. This further improves the hydrophilic/hydrophobic properties of the channels.

As Fig. 17-19 show a first embodiment of the method of forming a nano-structured foil 27, Fig. 24 to 31 show a second, alternative embodiment of this step.

In a first step of the second embodiment, a stamp 31, preferably comprising a semiconductor material, even more preferably consisting of silicon, with nanostructures 3 on its top surface is fabricated (Fig. 24). This can be done as described previously by spincoating of a resist onto a substrate material, coating the covered substrate with a metal, e.g. Nickel, lift-off of the metal at certain areas and finally etching to receive the nano-structured stamp 31.

From this stamp 31 a polymer stamp 33 may be fabricated by casting of a polymer material 32, preferably PDMS on the structured substrate 31. Then the polymer material 32 is cured and peeled-off to form the polymer stamp 33 (Fig. 26).

In the next step, a thermoplastic foil 27 is prepared with nanostructures for the later thermoforming process. The foil 27 now consists of different layers. First, a thermoplastic material layer 27a is covered by a polymer material layer 27b on its backside, e.g. by spincoating PDMS on the backside of the thermoplastic material layer 27a. The polymer material 27b is subsequently cured. The thickness of the polymer layer 27b is preferably between 10-30 µm. Next, an UV curing material layer 27c is formed on the front side of the thermoplastic material 27a for the UV-NIL step, preferably by spincoating. The UV curing material is preferably epoxy. The thickness of the UV curing material layer 27c depends on the height of the desired structures formed on the foil 27a. The three layered foil 27 can be seen in Fig. 27.

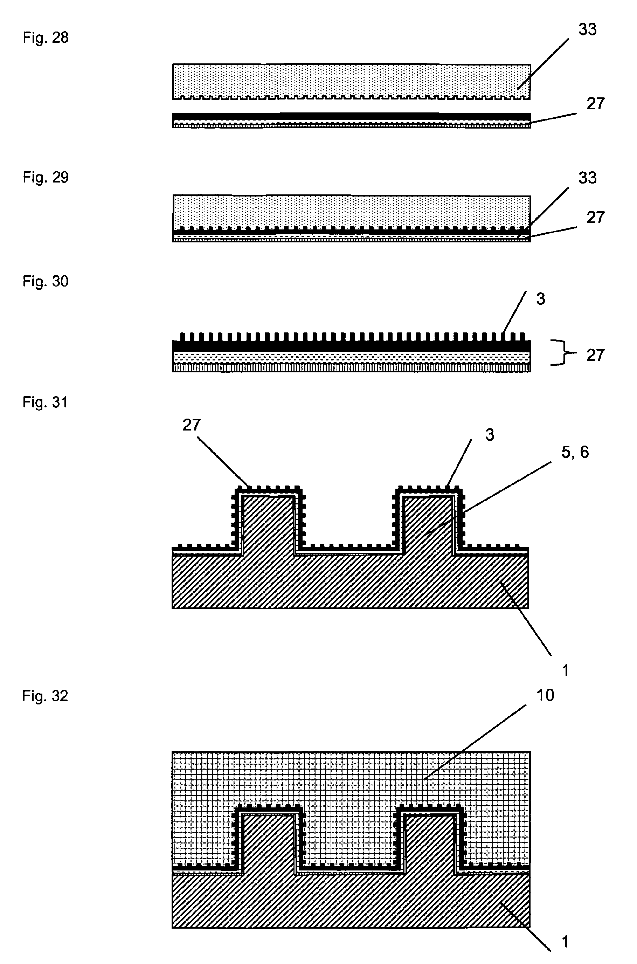

In a subsequent step, the polymer stamp 33, preferably a PDMS stamp, is brought in contact with the coated foil 27 (see Fig. 28). Upon making contact and applying pressure, the cavities of the polymer stamp are filed with the liquid UV curing material. Then, the stamp together with the foil 27 is exposed to UV radiation for curing the UV curing material 27c (Fig. 29). Finally, the polymer stamp 33 is peeled-off the foil 27 to obtain a structured foil 27 with nanostructures on top as shown in Fig. 30 (exaggerated).

In a thermoforming process step, the structured foil 27 is then applied to a first substrate 1 with first and second microstructures 5, 6 in Fig. 31. The structured foil 27 is deformed to be aligned with the substrate 1 and the assembly is heated up to a temperature above the glass transition temperature of the foil 27. A pressure is applied to blow the foil into the inserts between the microstructures 5, 6 of the substrate and the assembly is cooled down to obtain a foil 27 maintaining its form and shape. Finally, the pressure is released.

From this a polymer stamp 11 may be formed by a casting process. A polymer material 10, preferably PDMS, is casted onto the foil covered substrate 1 (Fig. 32). The polymer material is cured and released of the substrate 1.

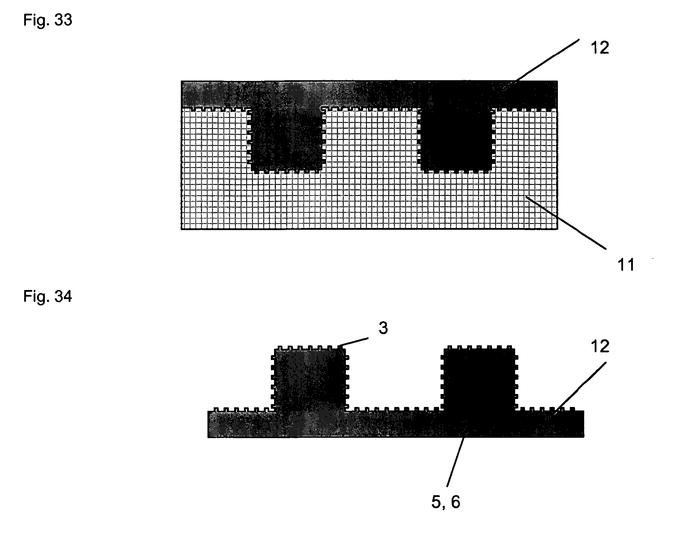

Then, the final polymer product 12 is casted into the polymer stamp 11 and cured by UV exposure. Finally, the cured polymer product 12 having nanostructures 3 and microstructures 5, 6 is released (Fig. 34).

In contrast to the first embodiment of the foil structuring as shown in Fig. 17-23, the second embodiment as shown in Fig. 24-34 employs an UV-NIL process instead of hot-embossing of nanostructures into the foil 27. This UV-NIL process allows the use of higher temperatures and pressure without affecting the quality of the nanostructures. Aspect ratios larger than 5, preferably even larger than 10, can be achieved, whereas the hot-embossing step only leads to aspect ratios below 3. During the thermoforming process of the foil 27 onto the first substrate 1, no structure deformation of the foil 27 is exhibited due to the higher glass transition temperature of the UV curing material. Moreover, the foil structuring processes of nanostructures allow using a variety of different microstructure patterning methods like micro-milling, for instance, as the nanostructures can be formed separately before application to the microstructures.

The additional polymer membrane or layer on the backside of the foil 27a allows the use of thinner thermoplastic material layers 27a in comparison to the foil 27 of the first embodiment without the risk of cracking since the polymer layer stabilizes the foil material 27a. Furthermore, higher pressures and temperatures can be applied which leads to an improved molding quality. Also, more complex structures can be formed and a higher process stability can be achieved. Furthermore, the shape of the nanostructures is not influenced by the thermoforming step because the used UV curing material, preferably an epoxy material, has a higher glass transition temperature than the thermoplastic material 27a.

To conclude, the methods according to the invention allow the integration of nanostructures, microstructures and through-hole into a final product in a single casting step.

Although some exemplary embodiments of the present invention have been shown and described herein, it will be appreciated by those skilled in the art that changes may be made from these embodiments without departing from the scope of the invention which is defined in the claims and their equivalents.

### List of reference signs

- 1: first substrate
- 2: first resist
- 3: nanostructures
- 4: second resist
- 5: first microstructures
- 6: second microstructures
- 7: through-hole
- 8: second substrate
- 9: pre-master
- 10: polymer-elastomer material
- 11: polymer stamp
- 12: final product
- 13: outlet/inlet
- 14: through-hole fabrication structure
- 15: hydrophilic nanostructured surfaces
- 16: hydrophobic nanostructured surfaces
- 17: inlet/outlet
- 18: fuel
- 19: by-products
- 20: oxygen
- 21: water
- 22: fuel delivery system
- 23: first electrode
- 24: membrane
- 25: second electrode
- 26: water management / oxygen inlet system
- 27: foil
- 28: side walls
- 31: stamp
- 32: polymer material
- 33: polymer stamp

## Claims

1. Method of producing a polymer stamp for the reproduction of devices comprising microstructures and nanostructures, the method comprising the steps of:
providing a thermoplastic foil (27);
providing a first substrate (1);
patterning nanostructures (3) into the thermoplastic foil (27);
patterning microstructures (5, 6) onto the first substrate (1);
covering the first substrate (1) surface comprising the microstructures (5, 6) with the nanostructured thermoplastic foil (27);
casting a polymer elastomer onto the first substrate (1) with nanostructures (3) and
microstructures (5, 6) to form a polymer stamp (11);
releasing the polymer stamp (11).

2. Method of producing a polymer stamp of claim 1, wherein the step of patterning nanostructures (3) into the thermoplastic foil (27) comprises the step of:
forming hydrophilic sections along a first direction and hydrophobic sections along a second, different direction by arranging the nanostructures (3) to extend along a first direction, the second direction being preferably perpendicular to the first direction.

3. Method of producing a polymer stamp of claim 1 or 2, wherein the step of patterning nanostructures (3) into the thermoplastic foil (27) comprises the step of hot-embossing nanostructures (3) into the foil (27).

4. Method of producing a polymer stamp of claim 1 or 2, wherein the step of patterning nanostructures (3) into the thermoplastic foil (27) comprises the steps of imprinting the nanostructures (3) onto the thermoplastic foil (27) by UV nanoimprinting lithography.

5. Method of producing a polymer stamp of claim 4, wherein UV nanoimprinting lithography step comprises the steps of:
forming a thermoplastic foil (27) by providing a thermoplastic material layer (27a),
covering one side of the thermoplastic material layer (27a) with a polymer material layer (27b) and covering the opposite side of the thermoplastic material layer (27a) with an UV curing material layer (27c),
making contact between a polymer stamp (33) with nanostructure cavities and the side of the thermoplastic material layer (27a) where the UV curing material layer (27c) is applied,
filling of the nanostructure cavities in the polymer stamp (33) with UV curing material of the UV curing material layer (27c),
exposing the assembly to UV radiation, and
peeling-off the polymer stamp (33) of the thermoplastic foil (27).

6. Method of producing a polymer stamp of claim 5, wherein the polymer stamp (33) with nanostructure cavities is formed by the steps of providing a substrate material, covering the substrate material with a resist, structuring the resist, coating a metal onto the covered substrate, lifting-off the metal partially to form nanostructures and etching the substrate.

7. Method of producing a polymer stamp of any of the previous claims, wherein the step of covering the first substrate (1) surface comprises the step of deforming the thermoplastic foil (27) onto the microstructures (5, 6) by thermoforming.

8. Method of producing a polymer stamp of any of the previous claims, wherein the thermoforming step comprises heating up the first substrate (1) with the thermoplastic foil (27) on top to a temperature above the glass transition temperature of the foil (27).

9. Method of producing a polymer stamp of one of the previous claims, wherein the step of patterning nanostructures (3) comprises at least one of the steps of forming the nanostructures (3) as lines and spaces extending in the first direction.

10. Method of producing a polymer stamp of one of the previous claims, wherein the step of pattering microstructures (5, 6) comprises at least one of the steps of:
forming first microstructures (5) to extend along the first direction to form hydrophilic channels together with the nanostructures (3) extending in said first direction, and forming second microstructures (6) to extend along a second, different direction to form hydrophobic channels together with the nanostructures (3) extending in the first direction.

11. Method of producing a polymer stamp of any of the previous claims, wherein the microstructure patterning step comprises at least one of the steps of:
covering the first substrate (1) with a second resist (2) being a photo resist and
performing a lithography process to form microstructures in the second resist (2), and
forming a through hole (7) through the second resist (2) and the first substrate (1).

12. Method of reproducing devices comprising microstructures and nanostructures comprising the steps of:
casting a final product material onto the polymer stamp (11) comprising microstructures (5, 6) and nanostructures (3) produced by any of claims 1 to 11,
wherein the microstructures (5, 6) and nanostructures (3) are transferred during the casting step to the final product (12), and
releasing the final product (12) of the polymer stamp (11).

13. Method of reproducing devices according to claim 12, wherein the final product material used for casting is a polymer material.

14. Polymer stamp (11) comprising:
first microstructures (5) extending along a first direction,
second microstructures (6) extending along a second direction different from the first direction, and
nanostructures (3) being provided to extend at least along said first direction,
wherein the nanostructures (3) are patterned into the at least one surface of the first and/or second microstructures (5, 6) and are formed of the same material as the microstructures (5, 6) themselves,
wherein the aspect ratio of a single nanostructure element is larger than 5,
**characterized in that**
the nanostructures (3) are formed on the bottom and the side walls of the first and/or
second microstructures (5, 6) of the polymer stamp (11).

15. Device comprising:
first microchannels (5) extending along a first direction,
second microchannels (6) extending along a second direction different from the first direction, and
nanostructures (3) provided to extend at least along said first direction,
wherein the nanostructures (3) are patterned into the surface of the microchannels (5, 6) and are formed of the same material as microchannels (5, 6) themselves wherein the aspect ratio of a single nanostructure element is larger than 5,
**characterized in that**
the nanostructures (3) are formed on the bottom and side walls of the first and/or
second microchannels (5, 6).

## Patentansprüche

1. Verfahren zur Herstellung eines Polymerstempels zum Abformen von Vorrichtungen mit Mikro- und Nanostrukturen, umfassend folgende Schritte:
Bereitstellen einer thermoplastischen Folie (27);
Bereitstellen eines ersten Substrats (1);
Erzeugen von Nanostrukturen (3) in der thermoplastischen Folie (27);
Erzeugen von Mikrostrukturen (5, 6) auf dem ersten Substrat (1);
Abdecken des ersten, die Mikrostrukturen (5, 6) umfassenden Substrates (1) mit der nanostrukturierten thermoplastischen Folie (27);
Gießen eines Polymer-Elastomers auf das erste Substrat (1) mit Nanostrukturen (3) und Mikrostrukturen (5, 6), um einen Polymerstempel (11) auszubilden;
Ablösen des Polymerstempels (11).

2. Verfahren zur Herstellung eines Polymerstempels nach Anspruch 1, wobei der Schritt des Erzeugens von Nanostrukturen (3) in der thermoplastischen Folie (27) folgenden Schritt umfasst:
Ausbilden hydrophiler Abschnitte entlang einer ersten Richtung und hydrophober Abschnitte entlang einer zweiten, anderen Richtung durch derartiges Anordnen der Nanostrukturen (3), dass sie sich entlang einer ersten Richtung erstrecken, wobei die zweite Richtung vorzugsweise senkrecht zur ersten Richtung ist.

3. Verfahren zur Herstellung eines Polymerstempels nach Anspruch 1 oder 2, wobei der Schritt des Erzeugens von Nanostrukturen (3) in der thermoplastischen Folie (27) den Schritt des Heiβprägens von Nanostrukturen (3) in die Folie (27) umfasst.

4. Verfahren zur Herstellung eines Polymerstempels nach Anspruch 1 oder 2, wobei der Schritt des Erzeugens von Nanostrukturen (3) in der thermoplastischen Folie (27) die Schritte des Prägens der Nanostrukturen (3) auf die thermoplastische Folie (27) durch UV-Nanoprägelithografie umfasst.

5. Verfahren zur Herstellung eines Polymerstempels nach Anspruch 4, wobei der UV-Nanoprägelithografie-Schritt folgende Schritte umfasst:
Ausbilden einer thermoplastischen Folie (27) durch Bereitstellen einer Thermoplastmaterialschicht (27a), Abdecken einer Seite der Thermoplastmaterialschicht (27a) mit einer Polymermaterialschicht (27b) und Abdecken der gegenüberliegenden Seite der Thermoplastmaterialschicht (27a) mit einer Schicht aus UV-härtendem Material (27c),
Herstellen eines Kontakts zwischen einem Polymerstempel (33) mit Nanostruktur-Hohlräumen und der Seite der Thermoplastmaterialschicht (27a), auf die die Schicht aus UV-härtendem Material (27c) aufgebracht wurde,
Füllen der Nanostruktur-Hohlräume im Polymerstempel (33) mit UV-härtendem Material der Schicht aus UV-härtendem Material (27c);
Bestrahlen der Anordnung mit UV-Strahlung;
Ablösen des Polymerstempels (33) von der thermoplastischen Folie (27).

6. Verfahren zur Herstellung eines Polymerstempels nach Anspruch 5, wobei der Polymerstempel (33) mit Nanostruktur-Hohlräumen durch die Schritte des Bereitstellens eines Substratmaterials, des Abdeckens des Substratmaterials mit einem Abdeckmittel, des Strukturierens des Abdeckmittels, des Beschichtens des abgedeckten Substrats mit einem Metall, des teilweisen Abhebens des Metalls, um Nanostrukturen auszubilden, und des Ätzens des Substrats ausgebildet wird.

7. Verfahren zur Herstellung eines Polymerstempels nach einem der vorangehenden Ansprüche, wobei der Schritt des Abdeckens der Oberfläche des ersten Substrats (1) den Schritt des Verformens der thermoplastischen Folie (27) auf den Mikrostrukturen (5, 6) durch Thermoformen umfasst.

8. Verfahren zur Herstellung eines Polymerstempels nach einem der vorangehenden Ansprüche, wobei der Schritt des Thermoformens das Erhitzen des ersten Substrats (1) mit der darauf befindlichen thermoplastischen Folie (27) auf eine Temperatur oberhalb der Erweichungstemperatur der Folie (27) umfasst.

9. Verfahren zur Herstellung eines Polymerstempels nach einem der vorangehenden Ansprüche, wobei der Schritt des Erzeugens von Nanostrukturen (3) mindestens einen der Schritte des Ausbildens der Nanostrukturen (3) als Linien und Räume, die sich in der ersten Richtung erstrecken, umfasst.

10. Verfahren zur Herstellung eines Polymerstempels nach einem der vorangehenden Ansprüche, wobei der Schritt des Erzeugens von Mikrostrukturen (5, 6) mindestens einen der folgenden Schritte umfasst:
Ausbilden erster Mikrostrukturen (5), die sich entlang der ersten Richtung erstrecken,
um gemeinsam mit den Nanostrukturen (3), die sich in der ersten Richtung erstrecken, hydrophile Kanäle auszubilden, und
Ausbilden zweiter Mikrostrukturen (6), die sich entlang einer zweiten, anderen Richtung erstrecken, um gemeinsam mit den Nanostrukturen (3), die sich in der ersten Richtung erstrecken, hydrophobe Kanäle auszubilden.

11. Verfahren zur Herstellung eines Polymerstempels nach einem der vorangehenden Ansprüche, wobei der Schritt des Erzeugens von Mikrostrukturen mindestens einen der folgenden Schritte umfasst:
Abdecken des ersten Substrats (1) mit einem zweiten Abdeckmittel (2), das ein Fotolack ist, und Ausführen eines Litografieverfahrens, um Mikrostrukturen im zweiten Abdeckmittel (2) auszubilden, und
Ausbilden eines Durchgangslochs (7) durch das zweite Abdeckmittel (2) und das erste Substrat (1 ).

12. Verfahren zum Abformen von Vorrichtungen mit Mikro- und Nanostrukturen, umfassend folgende Schritte:
Gießen eines Endproduktmaterials auf den Polymerstempel (11) mit Mikrostrukturen (5, 6) und Nanostrukturen (3), der nach einem(diese Ansprüche betreffen die Herstellung eines ...stempels) der Ansprüche 1 bis 11 hergestellt wurde, wobei die Mikrostrukturen (5, 6) und Nanostrukturen (3) während des Schritts des Gießens auf das Endprodukt (12) übertragen werden, und
Ablösen des Endprodukts (12) vom Polymerstempel (11).

13. Verfahren zum Abformen von Vorrichtungen nach Anspruch 12, wobei das für das Gießen verwendete Endproduktmaterial ein Polymermaterial ist.

14. Polymerstempel (11), umfassend:
erste Mikrostrukturen (5), die sich entlang einer ersten Richtung erstrecken,
zweite Mikrostrukturen (6), die sich entlang einer zweiten, von der ersten Richtung abweichenden Richtung erstrecken, und
Nanostrukturen (3), die bereitgestellt sind, um sich mindestens entlang der ersten Richtung zu erstrecken,
wobei die Nanostrukturen (3) in der mindestens einen Oberfläche der ersten und/oder zweiten Mikrostrukturen (5, 6) ausgebildet sind und aus demselben Material wie die Mikrostrukturen (5, 6) selbst ausgebildet sind,
wobei das Seitenverhältnis eines einzelnen Nanostrukturelements größer als 5 ist,
**dadurch gekennzeichnet, dass**
die Nanostrukturen (3) am Boden und an den Seitenwänden der ersten und/oder zweiten Mikrostrukturen (5, 6) des Polymerstempels (11) ausgebildet sind.

15. Vorrichtung, umfassend:
erste Mikrokanäle (5), die sich entlang einer ersten Richtung erstrecken,
zweite Mikrokanäle (6), die sich entlang einer zweiten, von der ersten Richtung abweichenden Richtung erstrecken, und
Nanostrukturen (3), die bereitgestellt sind, um sich mindestens entlang der ersten Richtung zu erstrecken,
wobei die Nanostrukturen (3) in der Oberfläche der Mikrokanäle (5, 6) ausgebildet sind und aus demselben Material wie die Mikrokanäle (5, 6) selbst ausgebildet sind,
wobei das Seitenverhältnis eines einzelnen Nanostrukturelements größer als 5 ist,
**dadurch gekennzeichnet, dass**
die Nanostrukturen (3) am Boden und an den Seitenwänden des ersten und/oder zweiten Mikrokanals (5, 6) ausgebildet sind.

## Revendications

1. Procédé de production d'un timbre en polymère pour la reproduction de dispositifs comprenant des microstructures et des nanostructures, le procédé comprenant les étapes consistant à :
réaliser une feuille thermoplastique (27) ;
réaliser un premier substrat (1) ;
modeler le contour de nanostructures (3) dans la feuille thermoplastique (27) ;
modeler le contour de microstructures (5, 6) sur le premier substrat (1) ;
couvrir la surface du premier substrat (1) comprenant les microstructures (5, 6) avec la feuille thermoplastique (27) nanostructurée ;
mouler un élastomère polymère sur le premier substrat (1) avec des nanostructures (3) et des microstructures (5, 6) pour former un timbre en polymère (11) ;
libérer le timbre en polymère (11).

2. Procédé de production d'un timbre en polymère selon la revendication 1, dans lequel l'étape de modelage du contour des nanostructures (3) dans la feuille thermoplastique (27) comprend l'étape consistant à :
former des sections hydrophiles le long d'une première direction et des sections hydrophobes le long d'une deuxième direction différente en agençant les nanostructures (3) pour qu'elles s'étendent le long d'une première direction, la deuxième direction étant de préférence perpendiculaire à la première direction.

3. Procédé de production d'un timbre en polymère selon la revendication 1 ou la revendication 2, dans lequel l'étape de modelage du contour des nanostructures (3) dans la feuille thermoplastique (27) comprend l'étape d'embossage à chaud des nanostructures (3) dans la feuille thermoplastique (27).

4. Procédé de production d'un timbre en polymère selon la revendication 1 ou la revendication 2, dans lequel l'étape de modelage du contour des nanostructures (3) dans la feuille thermoplastique (27) comprend les étapes consistant à imprimer les nanostructures (3) sur la feuille thermoplastique (27) par lithographie par nano-impression UV.

5. Procédé de production d'un timbre en polymère selon la revendication 4, dans lequel l'étape de lithographie par nano-impression UV comprend les étapes consistant à :
former une feuille thermoplastique (27) en réalisant une couche de matériau thermoplastique (27a), couvrir un côté de la couche de matériau thermoplastique (27a) avec une couche de matériau polymère (27b) et couvrir le côté opposé de la couche de matériau thermoplastique (27a) avec une couche de matériau de séchage sous UV (27c),
réaliser un contact entre un timbre en polymère (33) ayant des cavités de nanostructure et le côté de la couche de matériau thermoplastique (27a) où est appliquée la couche de matériau de séchage sous UV (27c),
remplir les cavités de nanostructure dans le timbre en polymère (33) avec le matériau de séchage sous UV de la couche de matériau de séchage sous UV (27c),
exposer l'ensemble aux rayons UV, et
détacher le timbre en polymère (33) de la feuille thermoplastique (27).

6. Procédé de production d'un timbre en polymère selon la revendication 5, dans lequel le timbre en polymère (33) ayant des cavités de nanostructure est formé par les étapes consistant à réaliser un matériau de substrat, couvrir le matériau de substrat avec une réserve, structurer la réserve, appliquer un revêtement métallique sur le substrat couvert, soulever partiellement le métal pour former des nanostructures et mordre le substrat.

7. Procédé de production d'un timbre en polymère selon l'une quelconque des revendications précédentes, dans lequel l'étape consistant à couvrir la surface du premier substrat (1) comprend l'étape consistant à déformer la feuille thermoplastique (27) sur les microstructures (5, 6) par thermoformage.

8. Procédé de production d'un timbre en polymère selon l'une quelconque des revendications précédentes, dans lequel l'étape de thermoformage comprend le chauffage du premier substrat (1), avec la feuille thermoplastique (27) en haut, à une température supérieure à la température de transition vitreuse de la feuille (27).

9. Procédé de production d'un timbre en polymère selon l'une des revendications précédentes, dans lequel l'étape de modelage des nanostructures (3) comprend au moins une des étapes consistant à former les nanostructures (3) sous forme de lignes et d'espaces s'étendant dans la première direction.

10. Procédé de production d'un timbre en polymère selon l'une des revendications précédentes, dans lequel l'étape de modelage des microstructures (5, 6) comprend au moins une des étapes consistant à :
former des premières microstructures (5) pour qu'elles s'étendent le long de la première direction pour former des canaux hydrophiles de concert avec les nanostructures (3) s'étendant dans ladite première direction, et
former des deuxièmes microstructures (6) pour qu'elles s'étendent le long d'une deuxième direction différente pour former des canaux hydrophobes de concert avec les nanostructures (3) s'étendant dans la première direction.

11. Procédé de production d'un timbre en polymère selon l'une quelconque des revendications précédentes 1, dans lequel l'étape de modelage des microstructures comprend au moins une des étapes consistant à :
couvrir le premier substrat (1) avec une deuxième réserve (2) qui est une résine photosensible et
effectuer un processus de lithographique pour former des microstructures dans la deuxième réserve (2), et
former un trou débouchant (7) à travers la deuxième réserve (2) et le premier substrat (1).

12. Procédé de reproduction de dispositifs comprenant des microstructures et des nanostructures, comprenant les étapes consistant à :
mouler un matériau de produit final sur le timbre en polymère (11) comprenant des microstructures (5, 6) et des nanostructures (3) produites selon l'une quelconque des revendications 1 à 11, dans lequel les microstructures (5, 6) et les nanostructures (3) sont transférées vers le produit final (12) pendant l'étape de moulage, et
libérer le produit final (12) du timbre en polymère (11).

13. Procédé de reproduction de dispositifs selon la revendication 12, dans lequel le matériau de produit final utilisé pour le moulage est un matériau polymère.

14. Timbre en polymère (11), comprenant :
des premières microstructures (5) s'étendant le long d'une première direction,
des deuxièmes microstructures (6) s'étendant le long d'une deuxième direction différente de la première direction, et
des nanostructures (3) réalisées pour s'étendre au moins le long de ladite première direction,
dans lequel les nanostructures (3) ont leur contour modelé dans la surface, au moins au nombre de un, des premières et/ou deuxièmes microstructures (5, 6) et sont formées du même matériau que les microstructures (5, 6) elles-mêmes,
dans lequel le rapport largeur/longueur d'un élément unique de nanostructure est supérieur à 5,
**caractérisé en ce que**
les nanostructures (3) sont formées sur le fond et les parois latérales des premières et/ou deuxièmes microstructures (5, 6) du timbre en polymère (11).

15. Dispositif comprenant :
des premiers microcanaux (5) s'étendant le long d'une première direction,
des deuxième microcanaux (6) s'étendant le long d'une deuxième direction différente de la première direction, et
des nanostructures (3) réalisées pour s'étendre au moins le long de ladite première direction,
dans lequel les nanostructures (3) ont leur contour modelé dans la surface des microcanaux (5, 6) et sont formées du même matériau que les microcanaux (5, 6) eux-mêmes,
dans lequel le rapport largeur/longueur d'un élément unique de nanostructure est supérieur à 5,
**caractérisé en ce que**
les nanostructures (3) sont formées sur le fond et les parois latérales des premiers et/ou des deuxièmes microcanaux (5, 6).
